# DEMANDE DE BREVET EUROPEEN

(11) **EP 1 993 203 A1**
(43) Date de publication de la demande: **19.11.2008**
(21) Numéro de dépôt: 07290646.4
(22) Date de dépôt: 18.05.2007
(51) Int. Cl.: H03F 1/32

(54) **Système de contrôle d'overdrive**

(71) Demandeur: STMicroelectronics SA, 92120 Montrouge (FR); STMicroelectronics S.r.l., 20041 Agrate Brianza (Milano) (IT)
(72) Inventeur: Calo', Pietro Antonio Paolo, 74014 Laterza (Taranto) (IT); Sirito-Olivier, Philippe, 13500 Carro Par Martiguez (FR); Chiricosta, Mario, 98121 Messina (IT)
(74) Mandataire: Ferrari, Barbara

(57) **Abrégé**

On décrit un système de contrôle d'overdrive (5), le système étant inséré entre une première et une deuxième référence de tension (VDD, GND) et ayant une borne d'entrée (IN1) et une borne de sortie (OUT1), connectées respectivement à une première et à une deuxième borne d'entrée (POSIN, FEEDBACK) d'un étage amplificateur (3).

Avantageusement selon l'invention, le système de contrôle d'overdrive (5) comprend:
- une source de courant contrôlée en tension (VCCS) émettant un courant de compensation (ICC) et étant insérée entre la première référence de tension (VDD) et un noeud interne (N1), connecté à son tour à la borne de sortie (OUTI), la source de courant contrôlée en tension (VCCS) ayant une borne de contrôle connectée à une borne de sortie d'un bloc additionneur (SN), ayant à son tour une entrée positive connectée à la borne d'entrée (IN1); et
- au moins un bloc de verrouillage (6), inséré entre la borne de sortie (OUT1) et la deuxième référence de tension (GND) et connecté à une entrée négative du bloc additionneur (SN).

La source de courant contrôlée en tension (VCCS) émette ainsi son courant de compensation (ICC) à la borne de sortie (OUT1) quand un signal de tension sur la borne d'entrée (IN) a une valeur supérieure à un signal de tension sur la borne de sortie (OUT) et elle force le signal de tension de sortie à suivre le signal de tension d'entrée jusqu'à un point qui dépend d'une tension de verrouillage (Vcl) fournie par le bloc de verrouillage (6).

## Description

### Domaine d'application

La présente invention concerne un système de contrôle d'overdrive, en particulier pour les amplificateurs à gain fixé.

Plus en particulier, l'invention concerne un système de contrôle d'overdrive inséré entre une première et une deuxième référence de tension et ayant une borne d'entrée et une borne de sortie, connectées respectivement à une première et à une deuxième borne d'entrée d'un étage amplificateur.

L'invention se réfère aussi à une méthode pour contrôler l'overdrive des bornes d'entrée d'un étage amplificateur.

L'invention concerne particulièrement, mais pas exclusivement, un système de contrôle d'overdrive pour un amplificateur à deux étages et la description qui suit n'est faite se référant à ce domaine d'application que par souci de clarté.

### Art technique

Comme il est bien connu, pour un système de communication moderne basé sur la transmission à lumière infrarouge, le conditionnement du signal avec une perte minimale de données est une spécification importante. Ce conditionnement du signal peut aussi devenir un problème dans plusieurs cas quand les impulsions lumineuses d'entrée avec un grand champ d'amplitude doivent etre transformées en un signal de courant ou de tension et ensuite amplifiées d'un gain fixé.

En effet, le moindre signal détectable fixe lui-même le gain mais il détermine aussi l'amplitude maximale d'un signal d'entrée avant qu'un amplificateur soit plongé dans une opération et saturation non-linéaire profonde.

Une réalisation traditionnelle d'un réseau de limitation à utiliser dans ces cas comprend simplement deux diodes Schottky et une résistance de limitation du courant. Ce reseau de limitation vise à éviter les saturations profondes des parties sensibles d'un circuit sécurisé. Il utilise un mécanisme de limitation d'entrée pour forcer une tension de sortie souhaitée. Autrement, on utilise un mécanisme direct de limitation de sortie.

Dans ces cas la sécurisation du circuit est activée en cas de défaut et aussi en cas de conditions operationnelles imprévues et elle empêche d'endommager le circuit lui-même.

En effet l'on sait qu'un tel circuit sécurisé ne peut pas opérer correctement (absence de conditions linéaires) tant que le réseau de limitation fonctionne.

Cependant, le temps de rétablissement d'un overdrive fermé devrait être au moins plus rapide d'un ordre de grandeur par rapport au temps normal de rétablissement de la saturation de l'amplificateur, permettant ainsi de rétablir rapidement l'opération linéaire.

En particulier, dans les systèmes de communication numérique opérant avec le type de donnée dit OOK [On-Off Keying], un étage récepteur de sortie est poussé à la limite de saturation par les normales conditions operationnelles d'entrée de façon à osciller entre les niveaux.

Quand un overdrive se produit, la saturation de l'étage de sortie devient un problème car, selon un niveau d'overdrive, il peut etre poussé bien au delà de la limite de saturation, entraînant ainsi une non-détection des impulsions lumineuses et un defaut dans la communication.

Le niveau de saturation est normalement contrôlé utilisant une boucle de contrôle opérant sur le gain du récepteur, l'ajustant selon les nécessités.

Cette solution connue ne peut pas être appliquée quand on doit utiliser une chaîne d'amplification en boucle ouverte.

En outre, les solutions connues ne peuvent pas opérer toujours correctement en cas de signal d'entrée de l'amplificateur ayant un grand champ et une petite perte de données ne peut pas être assurée à des niveaux supérieurs d'un tel signal d'entrée.

Le problème technique à la base de la présente invention est de fournir un système de contrôle d'overdrive ayant des caractéristiques structurelles et fonctionnelles permettant d'étendre le champ d'entrée de l'amplificateur sans changer profondément l'architecture de l'amplificateur et d'assurer une petite perte de données à des niveaux supérieurs du signal d'antrée de l'amplificateur, dépassant ainsi les limitations affectant encore les dispositifs réalisés selon l'art technique.

### Résumé de l'invention

L'idée de solution à la base de la présente invention est de fournir un mécanisme de verrouillage des bornes d'entrée et de sortie d'un étage amplificateur, ledit verrouillage dépendant de l'amplitude d'un signal d'entrée appliqué à de telles bornes d'entrée, pour permettre un rétablissement rapide d'une condition de saturation profonde sur la sortie d'un amplificateur comprenant l'étage amplificateur et pour empêcher la génération de fausses impulsions sur une borne de sortie de l'étage amplificateur après qu'une condition d'overdrive s'est produite.

Basé sur une telle idée de solution, le problème technique est résolu par un système de contrôle d'overdrive du type précédemment indiqué et défini par la partie caractérisante de la revendication 1.

Le problème est aussi résolu par une méthode de contrôle d'overdrive telle qu'elle a été précédemment indiquée et définie par la partie caractérisante de la revendication 15.

Les caractéristiques et avantages du système de contrôle d'overdrive selon l'invention seront claires de la description qui suit d'un exemple de réalisation donné à titre d'exemple indicatif et non limitatif avec référence aux figures ci-jointes.

### Brève description des figures

Dans les dessins:
La Figure 1 montre schématiquement un amplificateur de tension à deux étages comprenant un système de contrôle d'overdrive selon l'invention;
La Figure 2A montre schématiquement le système de contrôle d'overdrive selon l'invention;
La Figure 2B montre schématiquement une portion supplémentaire du système de contrôle d'overdrive selon l'invention;
Les Figures 3A et 3B montrent schématiquement de respectives exemples de réalisation circuitale du système de contrôle d'overdrive et de sa portion supplémentaire des figures 2A et 2B;
Les Figures 4A-4E montrent schématiquement la configuration des signaux internes d'un amplificateur de tension à deux étages qui respectivement comprend ou ne comprend pas le système de contrôle d'overdrive selon l'invention.

### Description détaillée

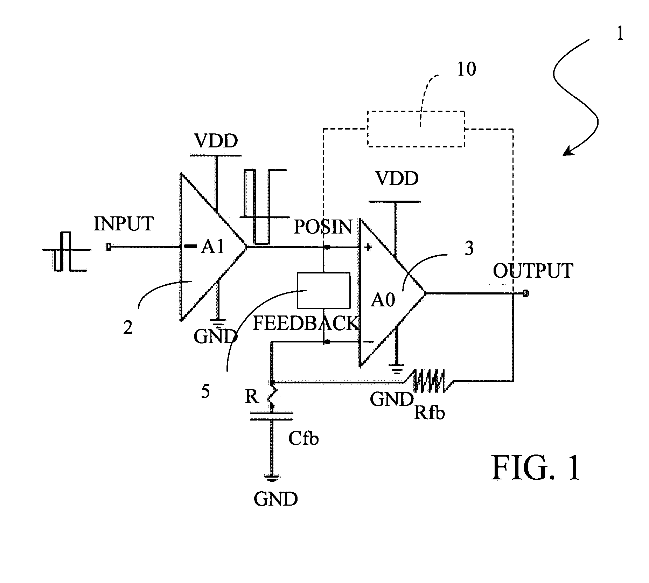

Se référant aux dessins, et particulièrement à la figure 1, un amplificateur de tension à deux étages est montré à titre d'exemple, globalement et schématiquement indiqué avec 1.

L'amplificateur de tension à deux étages 1 est inséré entre une première référence de tension, particulièrement une référence de tension d'alimentation VDD, et une deuxième référence de tension, particulièrement une masse GND, et il a une borne d'entrée INPUT et une borne de sortie OUTPUT.

Plus en particulier, l'amplificateur de tension à deux étages 1 comprend un premier étage amplificateur 2, ou d'entrée, et un deuxième étage amplificateur 3, ou de sortie, insérés entre la référence de tension d'alimentation VDD et la masse GND et connectés, en cascade entre eux, entre les bornes d'entrée et de sortie, INPUT et OUTPUT.

L'étage amplificateur d'entrée 2 a une borne d'entrée, particulièrement une borne inverseuse (-), connectée à la borne d'entrée INPUT de l'amplificateur de tension à deux étages 1 et recevant de celui-ci un signal d'entrée, et aussi une borne de sortie connectée à une première borne d'entrée, particulièrement une borne non inverseuse (+), indiquée avec POSIN, de l'étage amplificateur de sortie 3, ayant à son tour une deuxième borne d'entrée, particulièrement une borne inverseuse (-), indiquée avec FEEDBACK, connectée à la masse GND par la série d'une résistance de polarisation R et d'un condensateur à rétroaction Cfb.

L'étage amplificateur de sortie 3 a aussi une borne de sortie connectée à la borne de sortie OUTPUT de l'amplificateur de tension à deux étages 1 et, en rétroaction, à sa deuxième borne d'entrée FEEDBACK par le moyen d'une résistance à rétroaction Rfb.

Avantageusement selon l'invention, l'amplificateur de tension à deux étages 1 comprend aussi un système de contrôle d'overdrive 5 connecté entre les terminaux d'entrée POSIN et FEEDBACK de l'étage amplificateur de sortie 3. Il convient de noter que la description suivante d'un amplificateur à deux étages ne doit pas être considérée d'une façon limitative, étant donnée seulement à titre d'exemple, les mêmes considérations s'appliquant dans le cas d'un amplificateur à un étage, l'étage amplificateur de sortie 3 étant l'n-ème étage d'un tel amplificateur.

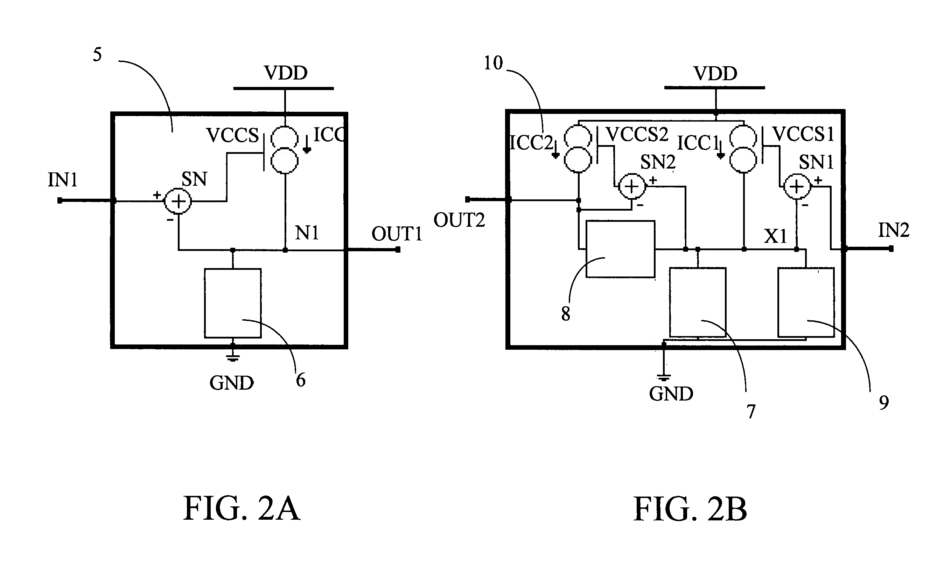

Un système de contrôle d'overdrive selon l'invention est montré schématiquement dans la figure 2A, globalement indiqué avec 5. Le système de contrôle d'overdrive 5 est inséré entre la référence de tension d'alimentation VDD et la masse GND et il a une borne d'entrée IN1 et une borne de sortie OUT1, connectées respectivement aux noeuds POSIN et FEEDBACK de l'étage amplificateur de sortie 3.

Plus en particulier, le système de contrôle d'overdrive 5 comprend une source de courant contrôlée en tension VCCS émettant un courant de compensation ICC et étant insérée entre la référence de tension d'alimentation VDD et un noeud interne N1, connecté à son tour à la borne de sortie OUT1. La source de courant contrôlée en tension VCCS a une borne de contrôle connectée à une borne de sortie d'un bloc additionneur SN, ayant lui même une entrée positive connectée à la borne d'entrée IN 1. En outre, le système de contrôle d'overdrive 5 comprend un bloc de verrouillage 6, inséré entre la borne de sortie OUT1 et la masse GND et connecté à une entrée négative du bloc additionneur SN.

De cette façon, quand un signal de tension sur la borne d'entrée IN1 a une valeur supérieure au signal de tension sur la borne de sortie OUT1, la source de courant contrôlée en tension VCCS fournit son courant de compensation ICC à la borne de sortie OUT1 forçant ainsi le signal de tension de sortie à suivre le signal d'entrée jusqu'à un niveau qui dépend d'une tension de verrouillage Vcl fournie par le bloc de verrouillage 6. En outre, quand ce bloc de verrouillage 6 est en fonction, il diminue un courant tant que le signal de tension d'entrée ne descend au dessous d'un point de verrouillage défini par la tension de verrouillage Vcl.

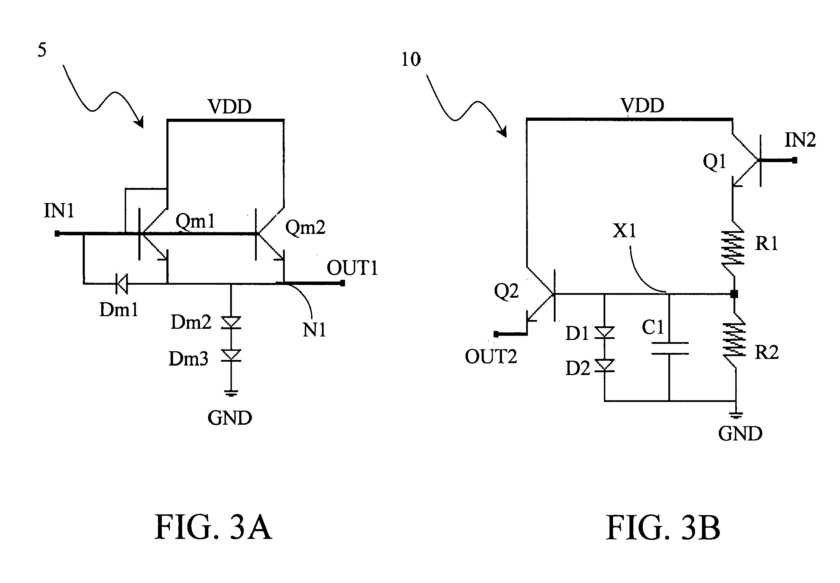

La Figure 3A montre un exemple de réalisation préféré du circuit du système de contrôle d'overdrive 5 selon le premier exemple de réalisation de la figure 2A.

En particulier, le système de contrôle d'overdrive 5 comprend un transistor d'entrée Qm1, en particulier un transistor bipolaire, inséré entre la référence de tension d'alimentation VDD et le noeud interne N1 et ayant une borne de contrôle ou de base connectée à sa borne de collecteur et à la borne d'entrée IN du système de contrôle d'overdrive 5. Le système de contrôle d'overdrive 5 comprend aussi un transistor de sortie Qm2, en particulier un transistor bipolaire, inséré entre la référence de tension d'alimentation VDD et la borne de sortie OUT1, connectée lui même au noeud interne N1, le transistor bipolaire de sortie Qm2 ayant sa borne de contrôle ou de base connectée à la borne de contrôle du transistor de la borne d'entrée Qm1.

Le système de contrôle d'overdrive 5 comprend aussi une première diode de verrouillage Dm1 insérée entre la borne d'entrée IN1 et le noeud interne N1, et aussi une deuxième et une troisième diode de verrouillage, Dm2 et Dm3, insérées, en série entre elles, entre le noeud interne N 1 et la masse GND.

Vu que le système de contrôle d'overdrive 5 est inséré entre les noeuds POSIN et FEEDBACK de l'étage amplificateur de sortie 3, comme montré dans la figure 1, quand une forte impulsion est appliquée à la borne d'entrée INPUT, une valeur de tension sur le noeud POSIN - pendant un front croissant de cette impulsion - est verrouillée doucement à une valeur de tension égale à une tension de diode au dessus de sa valeur DC, par le moyen de la première diode de verrouillage Dm1.

En outre, la borne de sortie OUT1 du système de contrôle d'overdrive 5, et donc le noeud FEEDBACK y connecté, est chargée par le moyen des transistors d'entrée et de sortie, Qm1 et Qm2, et sa valeur de tension suit la valeur de tension sur le noeud POSIN avant d'être verrouillée à une valeur de tension égale à deux tensions de diode, par le moyen de la deuxième et de la troisième diode, Dm2, Dm3.

De cette façon, la boucle de l'étage amplificateur de sortie 3 est ouverte, la différence de tension à travers les noeuds POSIN et FEEDBACK étant pourtant toujours bloquée à une valeur de tension égale à une tension de diode.

En substance, se référant au graphique par blocs de la figure 2A, le transistor d'entrée Qm1 réalise la source de courant contrôlée en tension VCCS, ses bornes de base et d'émetteur ayant la fonction du bloc additionneur SN tandis que la deuxième et la troisième diode Dm2 et Dm3 réalisent le bloc de verrouillage 6.

Il convient de noter que le bon fonctionnement du système de contrôle d'overdrive tel que montré dans les figures 2A et 3A est assuré si le signal de tension sur le noeud POSIN est raisonnablement un petit signal. Dans ce cas, le signal de tension sur la borne OUTPUT est une répétition amplifiée du signal de tension sur le noeud POSIN.

Quand cette condition de petit signal n'est pas satisfaite, avantageusement selon l'invention, le système de contrôle d'overdrive 5 comprend aussi un circuit de verrouillage supplémentaire, schématiquement montré dans la figure 2B et globalement indiqué avec 10.

Le circuit de verrouillage supplémentaire 10 est inséré entre la référence de tension d'alimentation VDD et la masse GND et il a une borne d'entrée IN2 et une borne de sortie OUT2, connectées respectivement aux noeuds OUTPUT et POSIN de l'étage amplificateur de sortie 3, tel que montré dans la Figure 1.

Plus en particulier, le circuit de verrouillage supplémentaire 10 comprend une première source de courant contrôlée en tension VCCS1 émettant un premier courant de compensation ICC1 et étant insérée entre la référence de tension d'alimentation VDD et un noeud de référence X1. La première source de courant contrôlée en tension VCCS1 a une borne de contrôle connectée à la borne de sortie d'un premier bloc additionneur SN1, ayant à son tour une entrée positive connectée à la borne d'entrée IN2 et une entrée négative connectée au noeud de référence X1.

Le circuit de verrouillage supplémentaire 10 comprend aussi une deuxième source de courant contrôlée en tension VCCS2 émettant un deuxième courant de compensation ICC2 et étant insérée entre la référence de tension d'alimentation VDD et la borne de sortie OUT2. La source supplémentaire de courant contrôlée en tension VCCS2 a une borne de contrôle connectée à une borne de sortie d'un deuxième bloc additionneur SN2, ayant à son tour une entrée positive connectée au noeud de référence X1.

En outre, le circuit de verrouillage supplémentaire 10 comprend un premier bloc de verrouillage 7 inséré entre le noeud de référence X1 et la masse GND et un deuxième bloc de verrouillage 8 inséré entre le noeud de référence X1 et la borne de sortie OUT, connectée à son tour à une entrée négative du deuxième bloc additionneur SN2.

Enfin, le circuit de verrouillage supplémentaire 10 comprend un bloc RC 9, en particulier un réseau RC, inséré entre le noeud de référence X1 et la masse GND.

De cette façon, la deuxième source de courant contrôlée en tension VCCS2 émet son deuxième courant de compensation ICC2 dans le bloc RC 9 de façon à augmenter un signal de tension sur le noeud de référence X1 jusqu'à une valeur qui ne dépassera pas une première tension de verrouillage Vcl1 du premier bloc de verrouillage 7. Quand le signal de tension sur la borne de sortie OUT2 diminue subitement - atteignant une valeur qui dépasse une deuxième tension de verrouillage Vcl2 du deuxième bloc de verrouillage 8 - la deuxième source de courant contrôlée en tension VCCS2 est activée pour émettre son deuxième courant de compensation ICC2. En effet, le noeud de référence X1 a une valeur de tension conservée par une constante de temps RC par le moyen du bloc RC 9.

Le deuxième courant de compensation ICC2 de la deuxième source de courant contrôlée en tension VCCS2 s'écoule à travers la borne de sortie OUT2, aidant ainsi le signal de tension de sortie à ralentir sa diminution.

La Figure 3B montre un exemple de réalisation préféré du circuit de verrouillage supplémentaire 10 de la figure 2B.

En particulier, le circuit de verrouillage supplémentaire 10 comprend un transistor d'entrée Q 1 et une résistance d'entrée R1 insérés, en série entre eux, entre la référence de tension d'alimentation VDD et le noeud de référence X1, le transistor d'entrée Q 1 ayant la borne de contrôle ou de base connectée à la borne d'entrée IN2 du circuit de verrouillage supplémentaire 10.

En outre, le circuit de verrouillage supplémentaire 10 comprend un transistor de sortie Q2 inséré entre la référence de tension d'alimentation VDD et la borne de sortie OUT2 et ayant sa borne de contrôle ou de base connectée au noeud de référence X1.

Le circuit de verrouillage supplémentaire 10 comprend aussi une première et une deuxième diode de verrouillage, D1 et D2, insérées, en série entre elles, entre le noeud de référence X1 et la masse GND, et aussi une résistance R et un condensateur C1 insérés, en parallèle entre eux, entre le noeud de référence X1 et la masse GND.

De cette façon, en cas d'ouverture de la boucle connectée à la borne de sortie OUTPUT de l'amplificateur de tension à deux étages 1, aussi dans la condition de petit signal, l'augmentation rapide de ce noeud à la valeur de la référence de tension d'alimentation VDD est interdite grâce au circuit de verrouillage supplémentaire 10.

En particulier, il faudrait noter que le noeud de référence X1 du circuit de verrouillage supplémentaire 10 sert de référence de tension.

Le condensateur C1 connecté à ce noeud de référence X1 est chargé par le signal de tension sur la borne d'entrée IN2 - connectée à la borne de sortie OUTPUT de l'amplificateur de tension à deux étages 1 - et il est aussi légèrement déchargé à travers la résistance R2. Autrement dit, le noeud de référence X1 ne peut pas dépasser une valeur de tension égale à deux tensions de diode à cause du verrouillage réalisé par les diodes de verrouillage D1 et D2.

De cette façon le signal de tension sur la borne de sortie OUT2 - connectée au noeud POSIN - dans un front descendant, diminue plus rapidement par rapport à la décharge du noeud de référence X1, de façon à ouvrir le transistor de sortie Q2 et à obtenir une valeur de tension égale à une tension de diode bloquée au dessous du noeud de référence X1, à cause de l'effet de verrouillage du condensateur C1.

En substance, le transistor d'entrée Q1 réalise la première source de courant contrôlée en tension VCCS1, ses bornes de base et d'émetteur ayant la fonction du premier bloc additionneur SN1, tandis que le transistor de sortie Q2 réalise la deuxième source de courant contrôlée en tension VCCS2, ses bornes de base et d'émetteur ayant la fonction du deuxième bloc additionneur SN2. En outre, les diodes de verrouillage, D1 et D2, le condensateur C1 et la résistance R2 forment les blocs de verrouillage 7, 8.

Autrement dit, le circuit de verrouillage supplémentaire 10 prévoit une rétroaction non-linéaire entre les noeuds POSIN et OUTPUT de l'étage amplificateur de sortie 3 et il empêche aussi une saturation profonde du noeud POSIN (étant connecté à la borne de sortie de l'étage amplificateur d'entrée 2), en le gardant légèrement au dessous de sa valeur DC à cause de l'effet du mécanisme de verrouillage réalisé par le circuit de verrouillage supplémentaire 10, tel qu'expliqué plus haut.

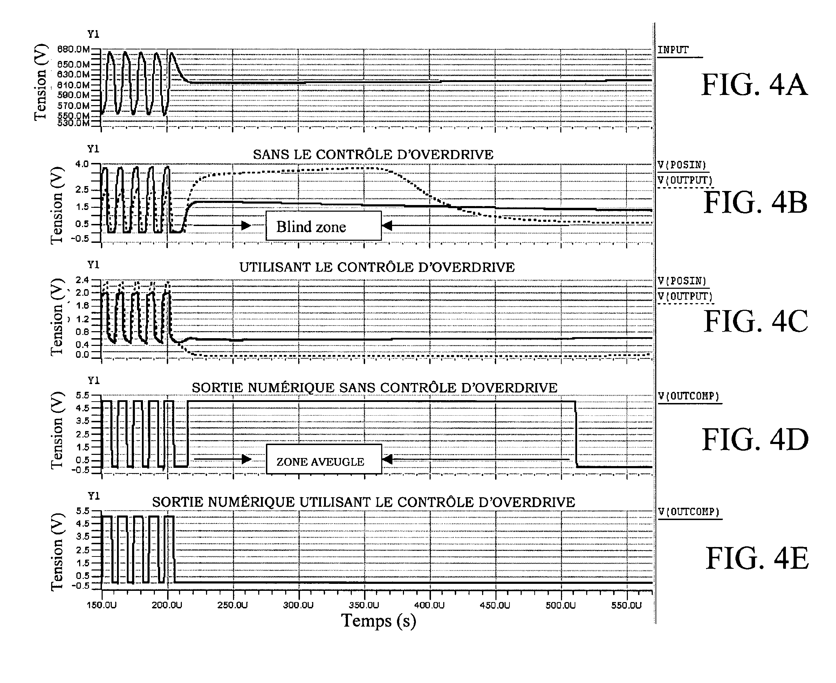

Les résultats des simulations effectuées par le Demandeur sont montrés dans les Figures 4A-4E.

En particulier, la Figure 4A montre une forme d'un signal d'entrée appliqué sur la borne d'entrée INPUT d'un amplificateur de tension à deux étages 1.

Les Figures 4C et 4B montrent les formes du signal de tension sur le noeud POSIN (trait plein) et du signal de sortie issu de la borne de sortie OUTPUT (ligne pointillée) de l'amplificateur de tension à deux étages 1 quand un système de contrôle d'overdrive 5 est respectivement utilisé ou non.

Les Figures 4E et 4D sont la version numérisée des impulsions d'entrée après l'amplification sur la sortie d'un comparateur final (non indiqué dans la figure 1) quand un système de contrôle d'overdrive 5 est respectivement utilisé ou non.

Il est donc bien évident que l'amplificateur de tension à deux étages 1 comprenant le système de contrôle d'overdrive 5 reconstruit correctement les impulsions d'entrée sur la borne de sortie d'un comparateur final de l'amplificateur de tension à deux étages 1, tandis que, utilisant des solutions connues sans le système de contrôle d'overdrive 5, on détecte une zone aveugle (montrée dans les Figures 4B et 4D) de fonctionnement erroné de l'amplificateur.

L'invention se réfère aussi à une méthode pour contrôler l'overdrive des bornes d'entrée d'un étage amplificateur, en particulier un étage amplificateur de sortie d'un amplificateur de tension à deux étages par système de contrôle d'overdrive 5. Plus en particulier, la méthode comporte les phases de:
- comparaison des signales de tension sur les bornes d'entrée et sortie, IN1 et OUT1, du système de contrôle d'overdrive 5; et
- quand le signal de tension sur la borne d'entrée IN1 a une valeur supérieure au signal de tension sur la borne de sortie OUT1, fourniture d'un courant de compensation ICC à la borne de sortie OUT1 par une source de courant contrôlée en tension VCCS.

Avantageusement selon l'invention, la phase de fourniture dudit courant de compensation ICC force le signal de tension sur la borne de sortie OUT1 à suivre le signal de tension sur la borne d'entrée IN1.

En outre, la méthode comporte une phase de limitation de la fourniture de courant de compensation ICC à une valeur du signal de tension sur la borne d'entrée IN 1 égale à une tension de verrouillage Vcl fournie par un bloc de verrouillage 6, qui est en fonction et diminue un courant tant que le signal de tension sur la borne d'entrée IN 1 ne descend au dessous d'un point de verrouillage défini par la tension de verrouillage Vcl.

Par ailleurs, la méthode comporte aussi une phase de fourniture d'un deuxième courant de compensation ICC2 de façon à augmenter un signal de tension sur un noeud de référence X1 intérieur au circuit de verrouillage supplémentaire 10 du système de contrôle d'overdrive 5 jusqu'à une valeur qui ne dépasse pas la tension de verrouillage Vcl.

Plus en particulier, quand le signal de tension sur la borne de sortie OUT2 du circuit de verrouillage supplémentaire 10 diminue subitement - atteignant une valeur qui dépasse une deuxième tension de verrouillage Vcl2 du deuxième bloc de verrouillage 8 - une deuxième source de courant contrôlée en tension VCCS2 est activée pour émettre son deuxième courant de compensation ICC2, comme expliqué plus haut.

En substance, le système et la méthode de contrôle d'overdrive proposés dépassent les désavantages affectant les solutions connues et fournit plusieurs avantages.

En particulier, le système de contrôle d'overdrive 5 selon l'invention permet un rétablissement rapide d'une condition de saturation profonde et il empêche la formation de fausses impulsions sur la sortie de l'amplificateur de tension à deux étages 1 après qu'une condition d'overdrive s'est produite.

Par voie de conséquence directe, il développe un champ d'opération dynamique du signal d'entrée.

D'une façon plus générale, l'amplificateur de tension à deux étages 1 comprenant un système de contrôle d'overdrive 5 réalise d'une façon simple un amplificateur à gain adaptatif.

## Revendications

1. Système de contrôle d'overdrive (5) inséré entre une première et une deuxième référence de tension (VDD, GND) et ayant une borne d'entrée (IN1) et une borne de sortie (OUT1), connectées respectivement à une première et à une deuxième borne d'entrée (POSIN, FEEDBACK) d'un étage amplificateur (3), **caractérisé en ce que** ledit système de contrôle d'overdrive (5) comprend:
- une source de courant contrôlée en tension (VCCS) émettant un courant de compensation (ICC) et étant insérée entre ladite première référence de tension (VDD) et un noeud interne (N1), connectés à son tour à ladite borne de sortie (OUT1), ladite source de courant contrôlée en tension (VCCS) ayant une borne de contrôle connectée à une borne de sortie d'un bloc additionneur (SN), ayant à son tour une entrée positive connectée à ladite borne d'entrée (IN1); et
- au moins un bloc de verrouillage (6), inséré entre ladite borne de sortie (OUT1) et ladite deuxième référence de tension (GND) et connecté à une entrée négative dudit bloc additionneur (SN)
ladite source de courant contrôlée en tension (VCCS) émettant ainsi son courant de compensation (ICC) à ladite borne de sortie (OUT1) quand un signal de tension sur ladite borne d'entrée (IN) a une valeur supérieure au signal de tension sur ladite borne de sortie (OUT) et forçant ledit signal de tension de sortie à suivre ledit signal de tension d'entrée jusqu'à un point qui dépend d'une tension de verrouillage (Vcl) fournie par ledit bloc de verrouillage (6).

2. Système de contrôle d'overdrive (5) selon la revendication 1, **caractérisé en ce qu'**il comprend un transistor d'entrée (Qm1) inséré entre ladite première référence de tension (VDD) et ledit noeud interne (N1) et ayant une borne de contrôle connectée à ladite borne d'entrée (IN1), et aussi un transistor de sortie (Qm2) inséré entre ladite première référence de tension (VDD) et ladite borne de sortie (OUT1), connectée à son tour audit noeud interne (N1), et ayant une borne de contrôle connectée à la borne de contrôle dudit transistor d'entrée (Qm1), ledit transistor d'entrée (Qm1) réalisant ladite source de courant contrôlée en tension (VCCS), se bornes de base et d'émetteur ayant la fonction dudit bloc additionneur (SN).

3. Système de contrôle d'overdrive (5) selon la revendication 2, **caractérisé en ce qu'**il comprend aussi au moins une première diode de verrouillage (Dm1) insérée entre ladite borne d'entrée (IN1) et ledit noeud interne (N 1).

4. Système de contrôle d'overdrive (5) selon la revendication 3, **caractérisé en ce qu'**il comprend aussi une deuxième et une troisième diode de verrouillage (Dm2, Dm3), insérées, en série entre elles, entre ledit noeud interne (N1) et ladite deuxième référence de tension (GND) et réalisant ledit bloc de verrouillage (6).

5. Système de contrôle d'overdrive (5) selon l'une quelquonque des revendications précédentes, **caractérisé en ce qu'**il comprend aussi un circuit de verrouillage supplémentaire (10) inséré entre lesdites première et deuxième références de tension (VDD, GND) et ayant une borne d'entrée (IN2) et une borne de sortie (OUT2), connectées respectivement à une borne de sortie (OUTPUT) et audit premier noeud d'entrée (POSIN) dudit étage amplificateur (3).

6. Système de contrôle d'overdrive (5) selon la revendication 5, **caractérisé en ce que** ledit circuit de verrouillage supplémentaire (10) comprend:
- une première source de courant contrôlée en tension (VCCS1) émettant un premier courant de compensation (ICC1), étant insérée entre ladite première référence de tension (VDD) et un noeud de référence (X1) dudit circuit de verrouillage supplémentaire (10) et ayant une borne de contrôle connectée à une borne de sortie d'un premier bloc additionneur (SN1), ayant à son tour une entrée positive connectée à ladite borne d'entrée (IN2) dudit circuit de verrouillage supplémentaire (10) et une entrée négative connectée audit noeud de référence (X1) ; et
- une deuxième source de courant contrôlée en tension (VCCS2) émettant un deuxième courant de compensation (ICC2), étant insérée entre ladite première référence de tension (VDD) et ladite borne de sortie (OUT2) dudit circuit de verrouillage supplémentaire (10) et ayant une borne de contrôle connectée à une borne de sortie d'un deuxième bloc additionneur (SN2), ayant à son tour une entrée positive connectée audit noeud de référence (X1).

7. Système de contrôle d'overdrive (5) selon la revendication 5, **caractérisé en ce que** ledit circuit de verrouillage supplémentaire (10) comprend aussi un premier bloc de verrouillage (7) inséré entre ledit noeud de référence (X1) et ladite deuxième référence de tension (GND) et un deuxième bloc de verrouillage (8) inséré entre ledit noeud de référence (X1) et ladite borne de sortie (OUT2) dudit circuit de verrouillage supplémentaire (10), ladite borne de sortie (OUT2) étant connectée à son tour à une entrée négative dudit deuxième bloc additionneur (SN2).

8. Système de contrôle d'overdrive (5) selon la revendication 7, **caractérisée en ce que** ledit circuit de verrouillage supplémentaire (10) comprend aussi un bloc RC (9) inséré entre ledit noeud de référence (X1) et ladite deuxième référence de tension (GND), ladite deuxième source de courant contrôlée en tension (VCCS2) émettant son deuxième courant de compensation (ICC2) dans ledit bloc RD (9) de façon à augmenter un signal de tension sur ledit noeud de référence (X1) jusqu'à une valeur qui ne dépassera pas une première tension de verrouillage (Vc11) dudit premier bloc de verrouillage (7), ladite deuxième source de courant contrôlée en tension (VCCS2) étant activée pour émettre son deuxième courant de compensation (ICC2) quand un signal de tension sur ladite borne de sortie (OUT2) dudit circuit de verrouillage supplémentaire (10) diminue subitement atteignant une valeur qui dépasse une deuxième tension de verrouillage (Vcl2) dudit deuxième bloc de verrouillage (8), ledit noeud de référence (X1) ayant une valeur de tension conservée par une constante de temps par le moyen dudit bloc RC (9).

9. Système de contrôle d'overdrive (5) selon la revendication 8, **caractérisé en ce que** ledit circuit de verrouillage supplémentaire (10) comprend un transistor d'entrée (Q1) et un résistance d'entrée (R1) insérés, en série entre eux, entre ladite première référence de tension (VDD) et ledit noeud de référence (X1), ledit transistor d'entrée (Q1) ayant une borne de contrôle connectée à ladite borne d'entrée (IN2) dudit circuit de verrouillage supplémentaire (10) et réalisant ladite première source de courant contrôlée en tension (VCCS1).

10. Système de contrôle d'overdrive (5) selon la revendication 9, **caractérisé en ce que** ledit circuit de verrouillage supplémentaire (10) comprend aussi un transistor de sortie (Q2) inséré entre ladite première référence de tension (VDD) et ladite borne de sortie (OUT2) dudit circuit de verrouillage supplémentaire (10) et ayant une borne de contrôle connectée audit noeud de référence (X1) et réalisant ladite deuxième source de courant contrôlée en tension (VCCS2).

11. Système de contrôle d'overdrive (5) selon la revendication 10, **caractérisé en ce que** ledit circuit de verrouillage supplémentaire (10) comprend aussi une première et une deuxième diode de verrouillage (D1, D2) insérées, en série entre elles, entre ledit noeud de référence (X1) et ladite deuxième référence de tension (GND).

12. Système de contrôle d'overdrive (5) selon la revendication 11, **caractérisé en ce que** ledit circuit de verrouillage supplémentaire (10) comprend aussi une résistance (R2) et un condensateur (C1) insérés, en parallèle entre eux, entre ledit noeud de référence (X1) et ladite deuxième référence de tension (GND), ledit condensateur (C1) étant chargé par un signal de tension sur ladite borne d'entrée (IN2) dudit circuit de verrouillage supplémentaire (10) et étant aussi légèrement déchargé à travers ladite résistance (R2), lesdites première et deuxième diodes de verrouillage (D1, D2), ladite résistance (R2) et ledit condensateur (C1) réalisant lesdits premier et deuxième blocs de verrouillage (7, 8).

13. Amplificateur de tension à deux étages (1) inséré entre une première et une deuxième référence de tension (VDD, GND) et ayant une borne d'entrée (INPUT) et une borne de sortie (OUTPUT) du type comprenant au moins un premier et un deuxième étage amplificateur (2, 3) insérés entre lesdites première et deuxième références de tension (VDD, GND) et connectés, en cascade entre eux, entre lesdites bornes d'entrée et de sortie (INPUT, OUTPUT), ledit premier étage amplificateur (2) ayant une borne de sortie connectée à une première borne d'entrée (POSIN) dudit deuxième étage amplificateur (3) ayant à son tour une deuxième borne d'entrée (FEEDBACK), connectée à ladite deuxième référence de tension (GND) par une série d'une résistance de polarisation (R) et d'un condensateur à rétroaction (Cfb), une résistance à rétroaction (Rfb) étant aussi connectée entre ladite deuxième borne d'entrée (FEEDBACK) et une borne de sortie dudit deuxième étage amplificateur (3), connecté à son tour à ladite borne de sortie (OUTPUT) dudit amplificateur de tension à deux étages (1), **caractérisé en ce qu'**il comprend aussi un système de contrôle d'overdrive (5) connecté entre lesdites première et deuxième bornes d'entrée (POSIN, FEEDBACK) dudit deuxième étage amplificateur (3) et réalisé selon l'une quelconque des revendications 1-12.

14. Amplificateur à gain adaptif du type comprenant au moins un étage amplificateur, **caractérisé en ce qu'**il comprend aussi un système de contrôle d'overdrive (5) réalisé selon l'une quelconque des revendications 1-12.

15. Méthode pour contrôler l'overdrive des bornes d'entrée d'un étage amplificateur **caractérisé en ce qu'**elle comporte les phases de:
- comparaison des signales de tension sur les bornes d'entrée et sortie (IN1, OUT1) d'un système de contrôle d'overdrive (5); et
- quand ledit signal de tension sur la borne d'entrée (IN1) a une valeur supérieure audit signal de tension sur la borne de sortie (OUT1), fourniture d'un courant de compensation (ICC) à ladite borne de sortie (OUT1) par une source de courant contrôlée en tension (VCCS).

16. Méthode pour contrôler l'overdrive selon la revendication 15, **caractérisée en ce qu'**elle comporte aussi une phase de limitation de ladite fourniture de courant de compensation (ICC) à une valeur dudit signal de tension sur ladite borne d'entrée (IN1) égale à une tension de verrouillage (Vcl) fournie par un bloc de verrouillage (6), qui est en fonction et diminue un courant tant que ledit signal de tension sur ladite borne d'entrée (IN1) ne descend au dessous d'un point de verrouillage défini par ladite tension de verrouillage (Vcl).

17. Méthode pour contrôler l'overdrive selon la revendication 16, **caractérisée en ce qu'**elle comporte aussi une phase de fourniture d'un deuxième courant de compensation (ICC2) de façon à augmenter un signal de tension sur un noeud de référence (X1) intérieur à un circuit de verrouillage supplémentaire (10) dudit système de contrôle d'overdrive (5) jusqu'à une valeur qui ne dépasse pas ladite tension de verrouillage (Vcl).
